# FASCICULE DE BREVET EUROPEEN

(11) **EP 2 093 868 B1**
(45) Date de publication et mention de la délivrance du brevet: **12.04.2017**
(21) Numéro de dépôt: 09153034.5
(22) Date de dépôt: 17.02.2009
(51) Int. Cl.: H02M 1/08, H03K 17/567, H03K 17/16, H03K 17/66, H03K 17/12

(54) **Dispositif et circuit de commande d'un composant électronique de puissance, procédé de pilotage et allumeur associés**
Steuervorrichtung und -schaltkreis einer elektronischen Leistungskomponente, entsprechendes Steuerungsverfahren und entsprechende Zündvorrichtung
Device and control circuit of an electronic power component, associated control method and distributor

(30) Priorité: 19.02.2008 FR 0851046
(43) Date de publication de la demande: 26.08.2009
(73) Titulaire: ALSTOM Transport Technologies, 93400 Saint-Ouen (FR)
(72) Inventeur: Lepage, Jean-Pierre, 65800 Aureilhan (FR)
(74) Mandataire: Lavoix

(56) Documents cités:
- DE-A1- 10 211 077
- DE-A1-102005 016 440
- DE-A1-102006 056 602
- JP-A- 6 196 978
- JP-A- 11 205 108
- JP-A- 2001 257 572
- JP-A- 2002 094 363
- JP-A- 2002 281 736
- US-A- 6 037 720
- US-A1- 2003 048 116
- US-A1- 2004 223 277
- US-A1- 2005 258 458

## Description

La présente invention concerne un dispositif, un circuit et un procédé de commande d'un composant électronique de puissance.

Les composants électroniques de puissance sont par exemple utilisés dans des dispositifs de commutation à haute tension pour « adapter » la forme d'un courant à son utilisation dans une machine tournante ou un moteur d'un véhicule électrique.

Le dispositif de commutation peut convertir du courant alternatif en courant continu ou l'inverse, ou modifier la forme, l'amplitude et la fréquence de l'onde du courant.

Le dispositif de commutation comporte des composants électroniques de puissance par exemple des transistors de puissance IGBT (Insulated Gate Bipolar Transistors), qui lorsqu'ils sont commutés d'un état d'ouverture à un état de fermeture, hachent une tension continue en ondes secondaires pour modifier la nature du courant et former par exemple un courant alternatif.

A cet effet, le dispositif de commutation reçoit des consignes de commande d'un calculateur qu'il traduit en commandes d'ouverture et de fermeture des transistors IGBT. Pour actionner l'ouverture ou la fermeture des transistors IGBT, une tension est appliquée entre l'électrode de grille et l'électrode d'émetteur des transistors IGBT. Cette application est généralement réalisée par des circuits RC (résistance- capacité).

Toutefois, les valeurs de résistivité et de capacitance des composants de ces circuits RC doivent être modifiées pour chaque nouvelle application, c'est- à dire à chaque fois que le dispositif de commutation commande une nouvelle machine ou même lorsque les paramètres de fonctionnement de cette nouvelle machine sont modifiés.

Le document US 200422327 divulgue un circuit de commande d'au moins un composant électronique de puissance propre à être commandé de façon à s'adapter à chaque nouvelle application sans avoir à changer des composants du circuit RC.
L'abstrait de la demande publiée Japonais JP2002094363 divulgue un circuit de commande (5a, 5b, 6a, 6b) de l'ouverture et de la fermeture d'un transistor de puissance (1), ledit circuit de commande comprenant un pont H composé des deux interrupteurs (6a, 6b) connectés en série et deux sources de courant contrôlés (5a, 5b) connectés en série, un point milieu entre les interrupteurs étant relié à la grille du transistor de puissance (1), et un point milieu entre les sources de courant contrôlés étant relié à l'émetteur du transistor de puissance.

Le but de la présente invention est de proposer un circuit de commande amélioré.

A cet effet, l'invention a pour objet un circuit de commande de l'ouverture et de la fermeture d'un composant électronique de puissance, un procédé de pilotage d'un circuit de commande, un ensemble comportant ledit circuit de commande et un dispositif de commande dudit circuit de commande selon les revendications.

L'invention sera mieux comprise à la lecture de la description qui va suivre, donnée uniquement à titre d'illustration, et faite en se référant aux dessins, sur lesquels :
- la figure 1 est une illustration schématique d'une chaîne de commande d'une machine tournante ;
- la figure 2 est une illustration schématique d'un interrupteur constitué de trois packs de composants électroniques de puissance ;
- la figure 3 est une illustration schématique de l'architecture d'un dispositif de commande et de trois circuits de commande propres à commander chacun un composant électronique de puissance d'un interrupteur ;
- la figure 4 est une illustration schématique du détail d'un circuit de commande illustré sur la figure 3 ;
- la figure 5 est un organigramme d'un procédé de pilotage des composants du circuit de commande illustré sur la figure 4 ;
- les figures 6 à 9 sont des illustrations schématiques représentant des parties du circuit de commande illustré sur la figure 4 ; et
- les figures 10 et 11 sont des graphiques illustrant l'évolution au cours du temps de différents paramètres de fonctionnement d'un composant électronique de puissance lors de l'application du procédé de la figure 5.

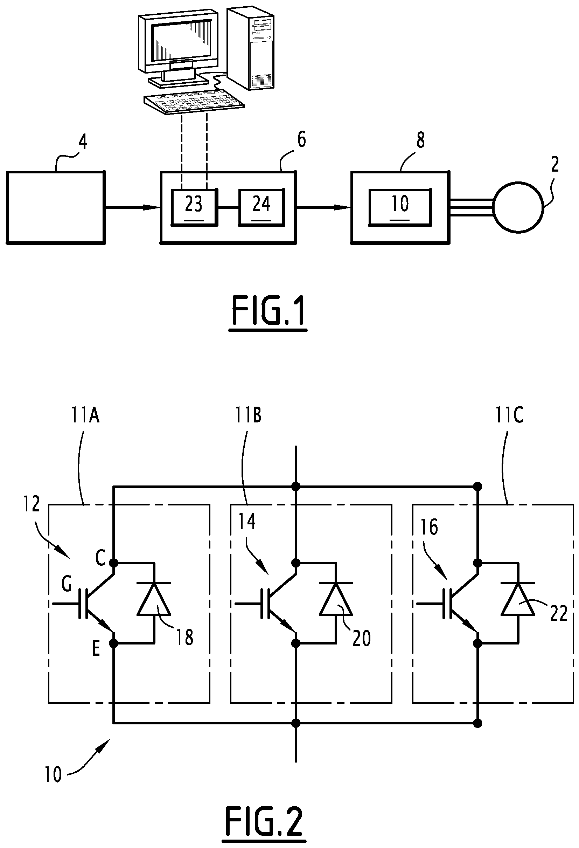

En référence à la figure 1, une chaîne de commande d'une machine électrique tournante 2 comprend de façon classique un calculateur 4 propre à délivrer des consignes de commande de puissance à un allumeur électronique 6. L'allumeur 6 a pour fonction de convertir ces consignes de commande de puissance en des instructions de commande d'un interrupteur 10 d'un dispositif de commutation 8.

Le dispositif de commutation 8 est par exemple un convertisseur DC/AC triphasé. Il comprend six interrupteurs 10.

Sur les figures 1 et 2, un seul interrupteur 10 a été représenté. Cet interrupteur 10 comprend trois packs 11A, 11B, 11C. Chaque pack 11A, 11B, 11C comprend un transistor 12, 14, 16 de puissance IGBT (Insulated Gate Bipolar Transistors) monté en antiparallèle avec sa diode 18, 20, 22. Chaque transistor de puissance comprend une électrode de grille, une électrode de collecteur et une électrode d'émetteur ci-après appelées grille, collecteur et respectivement émetteur.

Chaque transistor de puissance 12, 14, 16 est typiquement capable de commuter des courants allant jusqu'à 1200 A. L'interrupteur 10, c'est-à-dire les trois transistors 12, 14, 16 montés en parallèle, est capable de commuter des courants allant jusqu'à environ 2500 A. Chaque transistor de puissance 12, 14, 16 est capable de supporter une tension V_{CE} entre le collecteur et l'émetteur à l'état non passant, c'est-à-dire à l'état ouvert, allant jusqu'à 4000 V, et à l'état passant, c'est-à-dire à l'état fermé, une tension V_{CE} généralement inférieure à 5 V.

L'allumeur 6 est propre à commander la commutation de l'interrupteur 10. Il comprend un codeur/décodeur, un système d'alimentation et un système numérique non représentés.

Il comprend en outre une mémoire flash 23 et un dispositif de commande 24 de commutation des transistors de puissance du pack.

La mémoire flash 23 est propre à stocker des paramètres de fonctionnement et de commande des transistors de puissance 12, 14, 16. Elle est effaçable et réinscriptible électriquement. A cet effet, elle est munie de contacts électriques propres à être connectés à un ordinateur pour modifier les paramètres de fonctionnement et de commande des transistors de puissance 12, 14, 16, à chaque fois que le dispositif de commutation 8 commande une nouvelle machine.

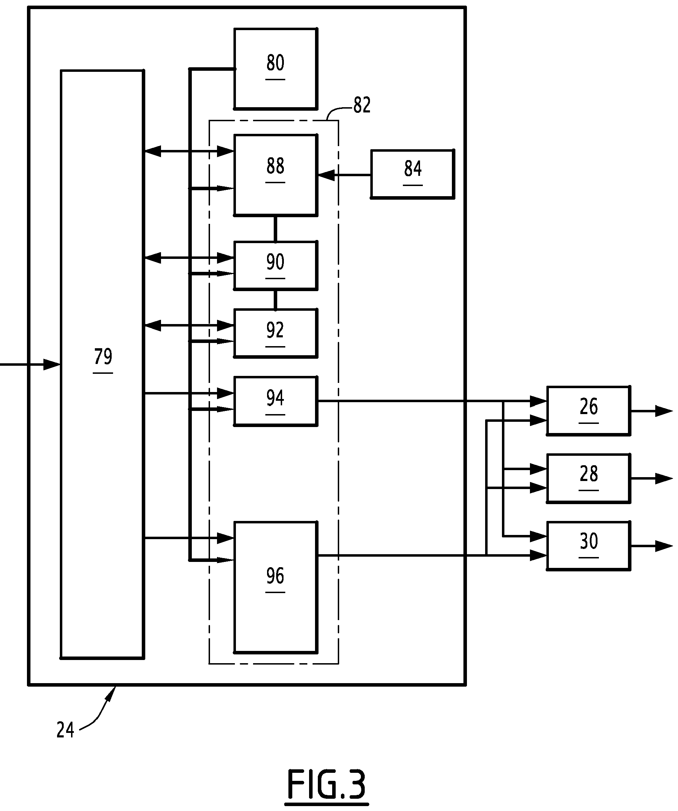

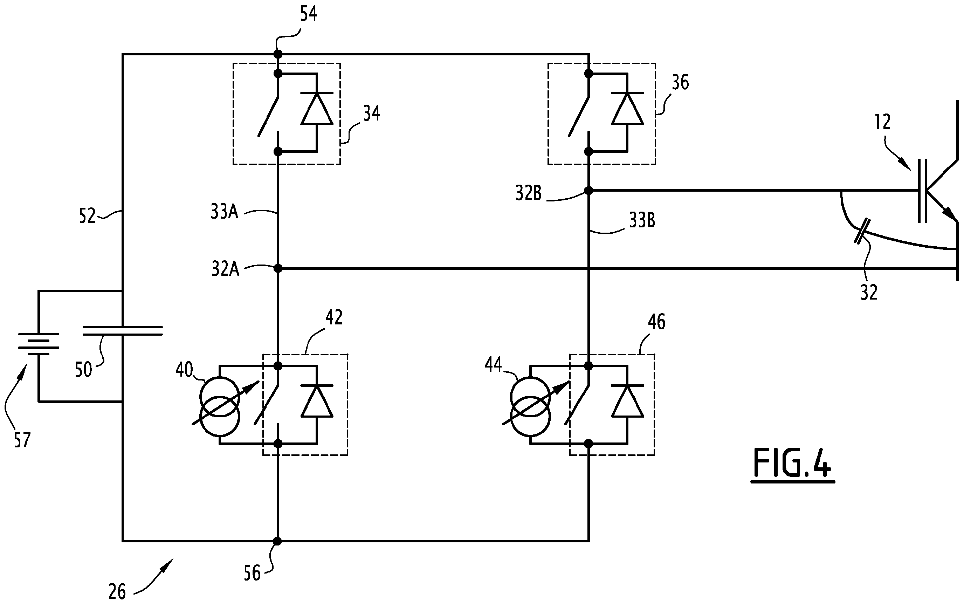

Le dispositif de commande 24 est illustré sur la figure 3. Il est implanté dans un réseau prédiffusé programmable par l'utilisateur, généralement appelé composant FPGA (de l'anglais « Field Programmable Gate Array »). Il comprend une logique de commande capable de commander de manière synchrone et indépendante trois circuits de commande 26, 28, 30, chacun propre à commander un couple grille / émetteur d'un transistor de puissance 12, 14, 16 de l'interrupteur 10. Seuls le circuit de commande 26 et le transistor de puissance 12 ont été illustrés sur la figure 4. Les circuits de commande 28 et 30 sont aptes à commander la commutation des transistors 14 et respectivement 16. Ces circuits sont identiques au circuit 26 et ne seront pas décrits en détail.

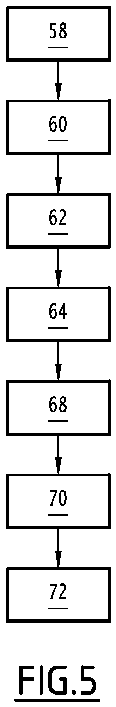

Comme le transistor de puissance 12 se comporte comme si il comprenait intrinsèquement un condensateur, il a été représenté sur les figures 4 à 9 avec un condensateur 32 relié à sa grille et à son émetteur.

Le circuit 26 est un pont en H qui sert à fixer le potentiel entre la grille et l'émetteur du transistor de puissance 12. Il est délimité par une ligne fermée et comprend deux liaisons électriques parallèles formant une première 33A et une seconde 33B branches verticales d'un H. La première branche 33A comporte un premier transistor MOS 34, un premier générateur de courant 40 relié en parallèle à un troisième transistor MOS 42. Le premier transistor MOS 34 est séparé de l'ensemble générateur de courant 40 - transistor MOS 42 par un point milieu 32A destiné à être relié à l'émetteur du transistor de puissance 12. La deuxième branche 33B comporte un deuxième transistor MOS 36, un deuxième générateur de courant 44 connecté en parallèle à un quatrième transistor MOS 46. Le deuxième transistor MOS 36 est séparé de l'ensemble générateur de courant 44 - quatrième transistor MOS 46 par un deuxième point milieu 32B destiné à être relié à la grille de transistor de puissance 12.

Lorsqu' aucune tension n'est appliquée sur leur grille, les transistors MOS laissent passer le courant de leur source vers leur drain (canal N) ou de leur drain vers leur source (canal P). C'est pourquoi, ceux-ci sont schématisés sur les figures 4 et 6 à 9 par des interrupteurs montés en parallèle avec une diode.

Les générateurs 40 et 44 sont des générateurs de courant à résistance variable commandés numériquement par l'intermédiaire d'un convertisseur numérique/analogique non représenté.

La commande de l'ouverture et de la fermeture des transistors MOS 34, 36, 42, 46 est réalisée directement par le dispositif de commande 24 ou par des unités de pilotage commandées par le dispositif de commande 24.

Les transistors MOS 34, 42 et 36, 46 sont des interrupteurs qui ont pour fonction de fixer la polarité de la grille et de l'émetteur du transistor de puissance 12 pour faire circuler un courant entrant dans la grille du transistor de puissance 12 (courant dans le sens des aiguilles d'une montre F1) ou sortant de celle-ci (courant dans le sens inverse des aiguilles d'une montre F2).

Le pont en H est alimenté par un condensateur 50 relié en un noeud 54 situé entre les transistors MOS 34 et 36, ainsi qu'en un noeud 56 situé entre les ensembles transistors MOS 34, 36 - générateurs de courant 40, 44. La tension du condensateur 50 est régulée à 15 V par une source de tension 57. Celle-ci fournit le courant nécessaire au fonctionnement en compensant les pertes joules inévitables dans le processus de commande de la grille du transistor 12.

Le procédé de pilotage du circuit 26 débute par une étape 58 au cours de laquelle il est vérifié que le condensateur 32 n'est pas en court-circuit en raison par exemple d'une panne d'un transistor MOS.

Si le condensateur 32 est en court-circuit, une procédure de sécurité est mise en place afin de ne pas endommager l'allumeur 6.

Si le condensateur 32 n'est pas en court-circuit, la tension V_{GE} entre la grille et l'émetteur du transistor 12 est initialement chargée à -15 V.

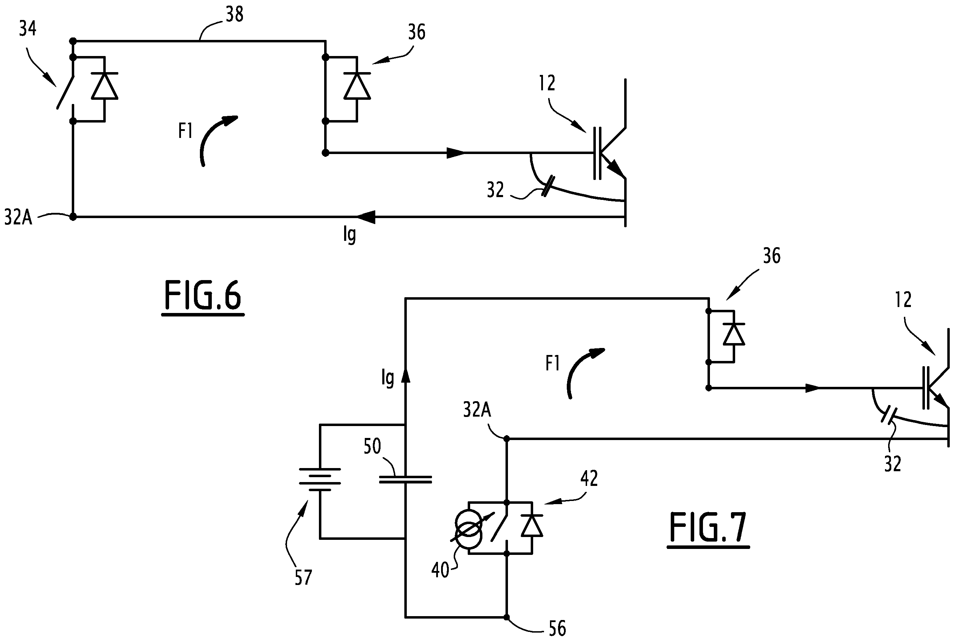

A l'étape 60, le transistor 36 est fermé, c'est-à-dire dans un état passant. Les transistors 42 et 46 sont dans un état ouvert, c'est-à-dire dans un état non passant. Les générateurs de courant 40, 44 sont mis hors tension ou hors circuit, c'est-à-dire qu'ils ne génèrent pas de courant. Un courant Ig de décharge du condensateur 32 s'établit dans la partie supérieure du pont en H dans le sens des aiguilles d'une montre F1 jusqu'à ce que la tension entre la grille et l'émetteur V_{GE} du transistor 12 soit environ égale à 0 V. La partie du circuit 26 dans laquelle le courant Ig circule est illustrée sur la figure 6.

Le courant Ig présente un pic de forte intensité comprise entre 5 et 10 A. Ce pic de courant permet d'amener la grille du transistor de puissance 12 au seuil de conduction.

Au cours de cette étape, la tension entre le collecteur et l'émetteur V_{CE} du transistor 12 est élevée (supérieure à la tension d'utilisation divisée par 2). Aucun courant ne passe entre le collecteur et l'émetteur du transistor de puissance 12.

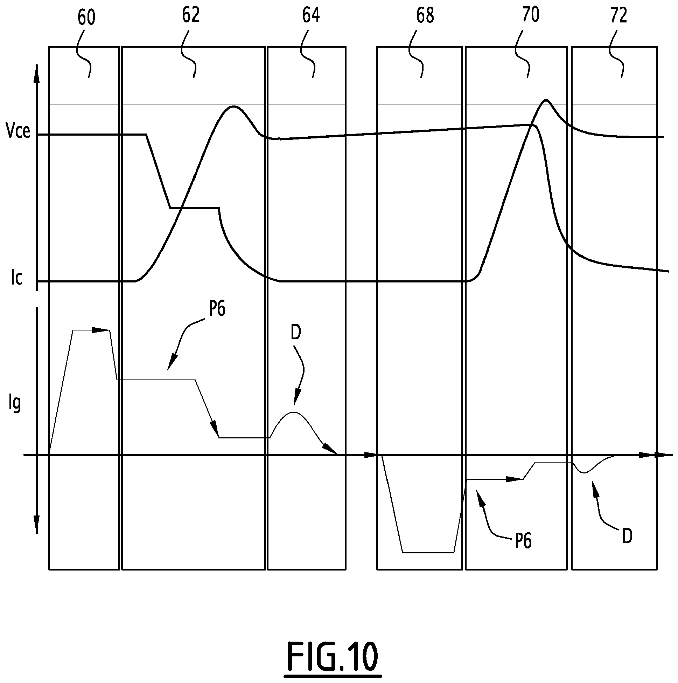

Au cours d'une étape 62, le générateur de courant 40 est mis sous tension pour générer un courant Ig. Ce courant Ig est injecté dans la grille du transistor de puissance 12 via le condensateur 50 et le transistor 36, comme visible sur les figures 7 et 10.

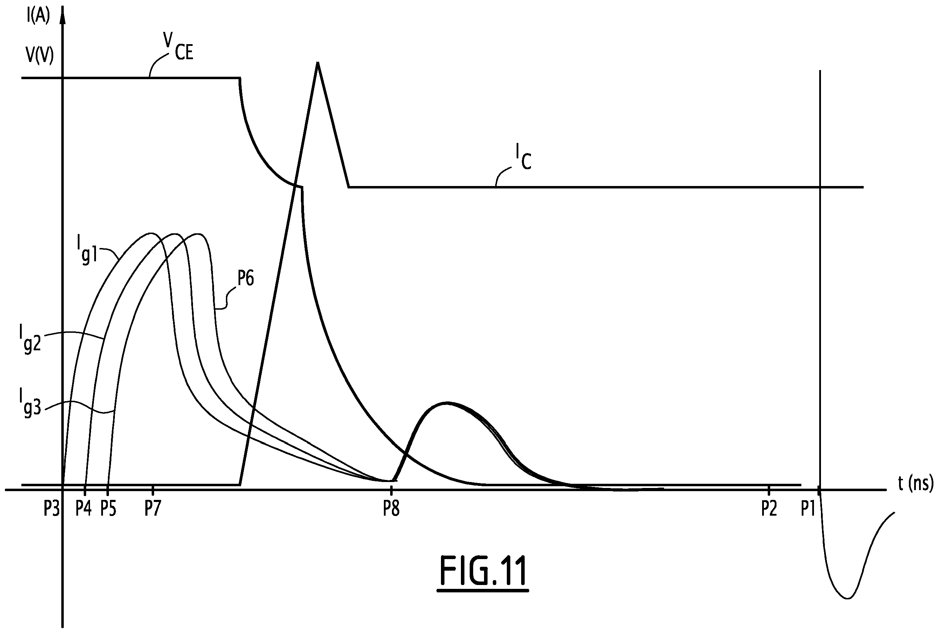

Le générateur 40 est commandé de manière à ce que le courant Ig diminue progressivement en suivant un profil de courbe prédéfini P6, puis le générateur 40 est mis hors tension. Le profil de courant P6 comprend un palier au moment où le transistor de puissance 12 passe à l'état passant, comme illustré sur la figure 10, ou varie selon une courbe exponentielle inverse comme illustré sur la figure 11.

Comme visible sur la figure 10, un courant Ic s'établit entre le collecteur et l'émetteur de ce transistor 12 tandis que la tension V_{CE} diminue progressivement.

Lorsque le courant Ig est trop important, le courant Ic qui s'établit entre le collecteur et l'émetteur du transistor 12 peut devenir brutalement trop important (dlc/dt trop élevé), ce qui peut entraîner des dommages irréversibles sur le transistor de puissance 12.

Comme le générateur de courant 40 selon l'invention est commandé numériquement, la diminution du courant Ig est réglé de façon précise par le dispositif de commande 24 afin d'éviter toute détérioration du transistor de puissance 12.

Avantageusement, ce profil de courbe P6 peut être facilement modifié lorsque le dispositif de commutation 8 est utilisé pour une nouvelle application, comme explicité ultérieurement.

Au cours d'une étape 64, le transistor 42 est fermé. Le condensateur 50 se décharge et génère une impulsion de décharge D visible sur la figure 10. Cette impulsion de décharge permet de maintenir le transistor de puissance 12 à l'état passant en évitant des phénomènes oscillatoires d'ouverture et de fermeture successives qui pourraient endommager le transistor 12.

La tension V_{CE} est alors environ égale à 5 V. La tension V_{GE} entre la grille et l'émetteur est de +15 V.

Pendant les étapes 60 et 64, la source de tension 57 recharge le condensateur 50 pour compenser les pertes par effet Joules accumulées pendant les cycles de charge et décharge du condensateur 32.

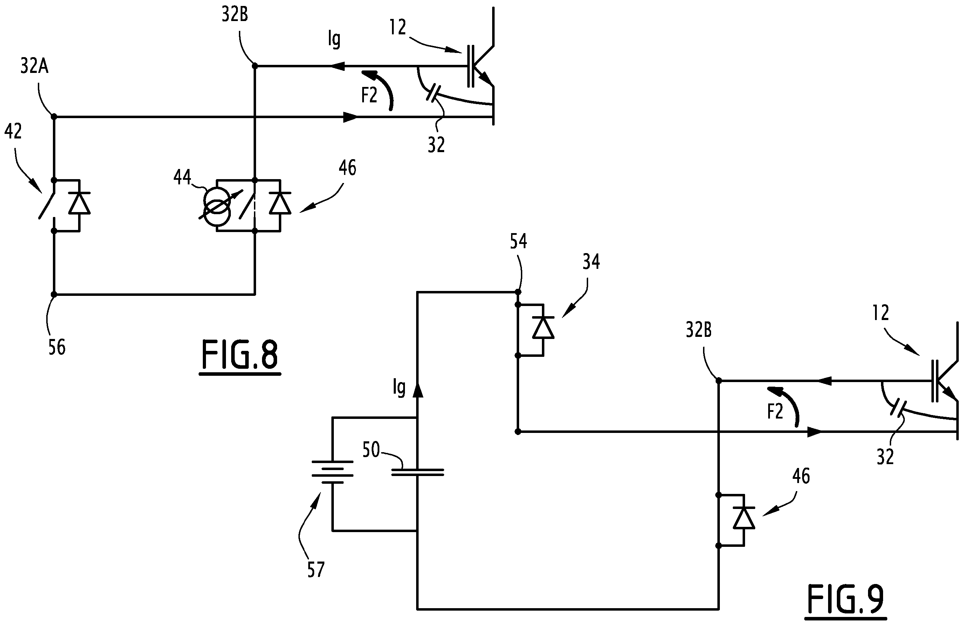

La procédure d'ouverture des transistors de puissance 12, 14, 16 débute par une étape 68 au cours de laquelle le transistor 46 est fermé (traits en pointillés sur la figure 8), les transistors 34, 36 et 42 étant ouverts. Un fort courant Ig de décharge du condensateur 32 s'établit dans le circuit 26 dans le sens inverse des aiguilles d'une montre F2 comme illustré sur les figures 8 et 10. Celui-ci atteint une valeur de 5 à 10 A selon le type d'IGBT. A la fin de l'étape 68, la tension V_{GE} est environ égale à la tension seuil de conduction de l'IGBT.

Ensuite, au cours d'une étape 70, le transistor 46 est ouvert (représenté en trait plein sur la figure 8) et le générateur de courant 44 est mis sous tension. Il génère un courant Ig de faible intensité dans le sens inverse des aiguilles d'une montre F2, comme illustré sur la figure 10.

Le courant Ig est progressivement diminué par le générateur de courant 44 et est éventuellement maintenu à un même niveau au moment où le transistor de puissance 12 passe à l'état bloqué ou non passant. Enfin, le générateur de courant 44 est mis hors tension.

Au cours d'une étape 72 illustrée sur la figure 9, les transistors 46 et 34 sont fermés. Le condensateur 50 génère une impulsion de courant de décharge D illustrée sur la figure 10. La décharge du condensateur 50 dans le condensateur 32 permet de ramener rapidement le courant circulant entre le collecteur et l'émetteur du transistor de puissance 12 à une valeur nulle. Cette impulsion permet d'éliminer le phénomène oscillatoire qui a généralement lieu lors de l'ouverture des transistors de puissance de nouvelle génération. Comme le courant Ic est rapidement ramené à 0, les pertes de commutation sont diminuées.

Au cours des étapes 68 et 72, la source de tension 57 recharge le condensateur 50 pour compenser les pertes par effet Joules accumulées pendant les cycles de charge et décharge du condensateur 32.

Les autres unités du dispositif de commande 24 vont à présent être décrites en liaison avec la figure 3.

Le dispositif de commande 24 comprend une unité de pilotage 79 propre à décider quelle tension V_{GE} doit être appliquée entre la grille et l'émetteur des transistors 12, 14, 16.

L'unité de pilotage 79 est une machine à états finis, capable de passer automatiquement d'un état de commande à un autre lorsqu'une condition de passage à l'état suivant est satisfaite.

L'unité de pilotage 79 est capable de convertir les consignes de commande de puissance du calculateur 4 réceptionnées par le codeur/décodeur de l'allumeur 6 en des signaux de contrôle pour injecter ou extraire du courant dans les grilles de transistors de puissance 12, 14, 16.

Le dispositif de commande 24 comprend en outre une mémoire 80, une unité de logique périphérique 82 et un circuit 84 d'acquisition d'informations relatives à la tension V_{CE} entre le collecteur et l'émetteur des transistors de puissance 12, 14, 16.

La mémoire 80 est une mémoire vive de type RAM à double port, préchargée depuis la mémoire 23 FLASH programmable électriquement. Elle contient des paramètres de fonctionnement de chaque transistor de puissance 12, 14, 16, et des paramètres de commande du courant Ig destiné à être appliqué à la grille et à l'émetteur de chaque transistor de puissance 12, 14, 16. Ces paramètres sont transférés depuis la mémoire flash 23 vers le port série de la mémoire 80 à la mise sous tension de l'allumeur 6 et sont ensuite aptes à être transférés depuis le port 16 bits de la mémoire 80 pour programmer l'unité de logique périphérique 82.

Lorsque le dispositif de commutation 8 est affecté à une nouvelle application, les paramètres de fonctionnement et les paramètres de commande peuvent être facilement modifiés par le branchement de la mémoire flash 23 à un ordinateur comportant un programme permettant de modifier ces paramètres.

Le circuit d'acquisition 84 est propre à déterminer à tout moment la tension V_{CE} entre le collecteur et l'émetteur des transistors de puissance 12, 14, 16, ainsi que la variation de celle-ci par rapport au temps. Le principe de fonctionnement de ce circuit est explicité dans la demande de brevet publiée sous le numéro 02 851 056, et ne sera pas décrit dans cette demande.

L'unité de pilotage 79 est apte à recevoir des informations de mesure de la tension V_{CE}, ainsi que des mesures de la variation de cette tension V_{CE} par rapport au temps, du circuit d'acquisition 84 pour contrôler en permanence la cohérence entre les consignes de commande reçues du calculateur 4 avec l'état de chaque transistor de puissance 12, 14, 16 tant au moment des commutations que pendant les états stationnaires.

L'unité de logique périphérique 82 comprend un bloc de filtrage temporel 88 des signaux reçus du circuit d'acquisition 84, un premier 90 et un second 92 chronomètres, une unité 94 de réglage du profil du courant injecté dans la grille des transistors de puissance 12, 14, 16 et enfin une unité de vérification 96.

Le bloc de filtrage temporel 88 est apte à réaliser un filtrage de la tension V_{CE} sur une plage temporelle prédéfinie pour enlever des signaux représentatifs de variations parasites de celles-ci.

Le premier chronomètre 90 est capable de chronométrer des temps de l'ordre de la dizaine de microseconde sur commande de l'unité de pilotage 79. Il est propre à recevoir de la mémoire 80 les paramètres de fonctionnement et les paramètres de commande. Celles-ci comprennent notamment la durée P1 minimale d'une impulsion tolérée sur la grille de chaque transistor de puissance 12, 14, 16, ainsi que le délai P2 minimum de saturation de chaque transistor de puissance, c'est-à-dire le délai minimum entre deux commandes de commutation. Des exemples de paramètres de fonctionnement et de paramètres de commande sont illustrés sur la figure 11.

Le second chronomètre 92 est capable de mesurer des temps de 25 ηs à quelques microsecondes sur commande de l'unité de pilotage 79. Il reçoit les paramètres à chronométrer de la mémoire 80. Il est notamment utilisé pour chronométrer les moments P3, P4, P5 d'injection des courants Ig dans chaque grille des transistors de puissance 12, 14, 16 de l'interrupteur, la longueur d'une impulsion de courant P7, ainsi que le temps de régulation P8.

L'unité de réglage 94 est apte à faire varier les courbes de courant Ig1, Ig2, Ig3 d'alimentation des transistors de puissance 12, 14, 16 selon un P6 ou plusieurs profils de courant prédéfinis reçus de la mémoire 80. Le profil de courant P6 peut former une marche d'escalier comme celui illustré sur la figure 10 ou une exponentielle décroissante, comme illustrée sur la figure 11.

L'unité de réglage 94 est propre à commander les générateurs de courant 40 et 44 des circuits de commande 26, 28 et 30. A cet effet, elle est connectée à des convertisseurs numériques analogiques, eux-mêmes reliés à chacun des générateurs 40, 44.

L'unité de vérification 96 reçoit des commandes de l'unité de pilotage 79 pour commander des unités de pilotage des transistors 34, 36, 42 et 46. L'unité de vérification 96 garantit le non recouvrement de conduction des transistors MOS. De plus, l'unité de vérification 96 permet de déclencher l'injection des courants Ig1, Ig2, Ig3 dans les grilles de chacun des transistors 12, 14, 16 aux moments P3, P4, P5 prédéfinis.

Les paramètres de fonctionnement et les paramètres de commande stockés dans la mémoire 80 comprennent notamment la durée P1 minimale d'une impulsion tolérée sur la grille de chaque transistor de puissance, le délai P2 minimum de saturation, les moments P3, P4, P5 d'injection de courant dans chaque grille des transistors de puissance 12, 14, 16, et le profil P6 de décroissance du courant de grille.

Le dispositif de commande 24 et les circuits de commande 26, 28, 30 permettent de commander de façon précise et rapide l'ensemble des trois transistors 12, 14, 16 en tenant compte de l'état de fonctionnement de chacun de ces transistors de puissance, le dispositif de commande 24 étant apte à mettre en place une procédure d'urgence en cas de dysfonctionnement de l'un ou plusieurs de ces transistors de puissance.

Les transistors de puissance 12, 14, 16 présentent des moments différents de passage de l'état passant à l'état non passant et vice-versa. Ces différences de moments de passage d'un état à l'autre sont issues de différences mineures dans le comportement de leur silicium, et de leur position dans la boucle de commutation de puissance. La disparité industrielle des paramètres des packs 11A, 11B, 11C et les dissymétries légères de la boucle de commutation apportent donc des déséquilibres dans la répartition instantanée du courant dans les packs en parallèle pendant les commutations. Ceci limite l'utilisation du plein pouvoir de coupure des packs dans les montages en parallèle.

Autrement dit, le premier transistor de l'interrupteur qui commute doit supporter un courant transitoire plus élevé que les autres jusqu'à ce que les autres transistors montés en parallèle soient totalement allumés. Pour cette raison, il est nécessaire de limiter le courant nominal de commutation du convertisseur, c'est-à-dire le courant commuté par l'interrupteur 10.

Les packs 11A, 11B, 11C sont testés préalablement à leur utilisation afin de déterminer exactement les écarts relatifs entre eux. Les moments de déclenchement P3, P4, P5 du courant Ig sont déterminés en fonction de ces écarts. L'unité de vérification 96 du dispositif de commande déclenche la mise en tension et la mise hors tension des générateurs de courant 40, 44 afin que l'ensemble des transistors de puissance 12, 14, 16 passe à l'état passant au même moment comme illustré sur la figure 11 de sorte que le courant nominal du convertisseur peut être augmenté.

En variante, les générateurs de courant 40, 44 peuvent être réalisés par des régulateurs de tension et des amplificateurs.

Dans les circuits de commande de l'état de la technique, l'énergie qui sert à commuter les transistors de puissance 12, 14, 16 est dissipée dans des résistances alors que avantageusement, dans la présente invention, cette énergie est récupérée par le condensateur 50. En conséquence, l'allumeur 6 consomme moins d'énergie et les composants des circuits de commande 26, 28, 30 ne sont pas chauffés et, donc pas abîmés.

Autrement dit, le principe de pilotage du couple grille / émetteur d'un transistor de puissance utilisé dans le circuit de commande de la présente invention permet de ne dissiper de l'énergie à l'allumage des transistors de puissance que pendant des étapes réduites. Ceci permet de diviser d'un facteur de 10 à 50 l'énergie dissipée par les circuits 26, 28, 30 lors de l'allumage des grilles des transistors de puissance. En effet, l'énergie est dissipée uniquement pendant les étapes 60 et 70 et il n'est pas nécessaire d'augmenter artificiellement le condensateur intrinsèque 32 des transistors de puissance 12, 14, 16 par l'ajout d'un condensateur extérieur supplémentaire pour ajuster un circuit RC.

## Revendications

1. Circuit de commande (26, 28, 30) de l'ouverture et de la fermeture d'un composant électronique de puissance (12, 14, 16), le composant électronique de puissance (12, 14, 16) ayant une électrode de grille, une électrode d'émetteur et une électrode de collecteur, **caractérisé en ce que** le circuit comprend un pont en H comprenant :
- une première branche verticale (33A) comprenant un premier interrupteur (34) et un premier générateur de courant (40) contrôlé numériquement, le premier interrupteur (34) étant séparé du premier générateur de courant (40) par un point milieu (32A) destiné à être relié à l'électrode d'émetteur du composant électronique de puissance (12, 14, 16); et
- une deuxième branche verticale (33B) parallèle à la première branche verticale (33A), la deuxième branche verticale (33B) comprenant un deuxième interrupteur (36) et un deuxième générateur de courant (44) contrôlé numériquement, le deuxième interrupteur (36) étant séparé du deuxième générateur (44) par un point milieu (32B) destiné à être relié à l'électrode de grille du composant électronique de puissance (12, 14, 16) ;
- le premier générateur de courant (40) étant propre à délivrer un courant d'alimentation (Ig) dirigé selon une première direction (F1) pour alimenter l'électrode de grille du composant électronique de puissance (12, 14, 16); et le deuxième générateur de courant (44) étant propre à délivrer un courant d'alimentation (Ig) dirigé selon une deuxième direction (F2) inverse à la première direction (F1) pour alimenter l'électrode d'émetteur du composant électronique de puissance (12, 14, 16).

2. Circuit de commande (26, 28, 30) selon la revendication 1, dans lequel le pont en H comporte un troisième interrupteur (42) relié en parallèle au premier générateur de courant (40), et un quatrième interrupteur (46) relié en parallèle au deuxième générateur de courant (44), et en ce que le circuit (26, 28, 30) comporte une source de courant (50, 57) propre à alimenter le pont en H, ladite source de courant étant connectée entre d'une part le premier (34) et le deuxième (36) interrupteurs, et d'autre part le premier (40) et le deuxième (44) générateurs de courant.

3. Circuit de commande (26, 28, 30) selon la revendication 2, dans lequel la source de tension (50, 57) comprend un condensateur (50).

4. Circuit de commande (26, 28, 30) selon l'une quelconque des revendications 1 à 3, dans lequel les interrupteurs (34, 36, 42, 44) sont des transistors de type MOS.

5. Procédé de pilotage d'un circuit de commande (26, 28, 30) selon l'une quelconque des revendications 1 à 4, **caractérisé en ce qu'**il comporte, sur une commande de fermeture du composant électronique de puissance (12, 14, 16) une étape (62) de délivrance, par le premier générateur de courant (40), d'un courant d'alimentation (Ig), le deuxième interrupteur (36) étant à l'état passant dans la première direction (F1).

6. Procédé de pilotage selon la revendication 5, lequel procédé comporte une étape préalable (60) de mise à l'état passant du deuxième interrupteur (36) dans ladite première direction (F1), le premier interrupteur (34) étant à l'état passant dans ladite première direction (F1).

7. Procédé de pilotage selon la revendication 5 ou 6 mis en oeuvre par le circuit selon la revendication 2, lequel procédé comporte :
- une étape (64) de mise à l'état passant du troisième interrupteur (42) dans la première direction (F1) ; le deuxième interrupteur (36) étant à l'état passant dans la première direction (F1) ;
- une étape (64) de délivrance, par la source de courant (50, 57), d'une impulsion de courant dirigée selon la première direction (F1).

8. Procédé de pilotage selon l'une quelconque des revendications 5 à 7, lequel procédé comporte, sur une commande d'ouverture du composant électronique de puissance (12, 14, 16) une étape (70) de délivrance, par le deuxième générateur de courant (44), d'un courant d'alimentation (Ig).

9. Procédé de pilotage selon la revendication 8 mis en oeuvre par le circuit selon la revendication 2, lequel procédé comporte une étape préalable (68) de mise à l'état passant du quatrième interrupteur (46) dans ladite deuxième direction (F2), le troisième interrupteur (42) étant à l'état passant dans ladite deuxième direction (F2).

10. Procédé de pilotage selon la revendication 8 ou 9 mis en oeuvre par le circuit selon la revendication 2, lequel procédé comporte :
- une étape (72) de mise à l'état passant du premier (34) et du quatrième (46) interrupteurs dans ladite deuxième direction inverse (F2) ; et
- une étape (72) de délivrance par la source de courant (50, 57) d'une impulsion de courant dans ladite deuxième direction (F2).

11. Procédé de pilotage selon la revendication 7 ou 10 mis en oeuvre par le circuit selon la revendication 3, dans lequel l'étape (64, 72) de délivrance de l'impulsion de courant est mise en oeuvre par la décharge du condensateur (50).

12. Procédé de pilotage selon l'une quelconque des revendications 5 à 11, dans lequel l'étape de délivrance d'un courant d'alimentation (Ig) comprend une étape (62, 70) de diminution progressive au cours du temps du courant d'alimentation (Ig) selon un profil prédéfini.

13. Ensemble comportant au moins un circuit de commande (26, 28, 30) selon l'une quelconque des revendications 1 à 4 et un dispositif de commande (24) dudit au moins un circuit de commande (26, 28, 30), le dispositif de commande (24) étant propre à recevoir des consignes de commande de puissance, et à commander le circuit de commande (26, 28, 30) pour ouvrir et fermer au moins un composant électronique de puissance (12, 14, 16) en fonction des consignes de commande de puissance, le dispositif (24) comprenant :
- une unité de pilotage (79) apte à convertir des consignes de commande de puissance en des signaux de commande d'ouverture et/ou de fermeture des interrupteurs (34, 36, 42, 46) et en des signaux de commande de mise sous tension et/ou de mise hors tension des générateurs de courant (40, 44) du circuit de commande (26, 28, 30) ;
- une mémoire (80) de stockage de paramètres de fonctionnement (P1, P2, P3, P4, P5, P6, P7, P8) du ou de chaque composant électronique de puissance (12, 14, 16), et de paramètres de commande du courant (Ig) destiné à être appliqué à l'électrode de grille et à l'électrode d'émetteur du ou de chaque composant électronique de puissance (12, 14, 16), ladite mémoire (80) étant effaçable et réinscriptible; et
- une unité de logique périphérique (82) apte à recevoir de ladite mémoire (30), les paramètres de fonctionnement et les paramètres de commande du courant d'alimentation (Ig), l'unité de logique périphérique (82) étant propre à exécuter des taches pour l'unité de pilotage (79) en fonction des paramètres de fonctionnement et des paramètres de commande de courant reçus.

14. Ensemble selon la revendication 13, le dispositif de commande (24) comprenant au moins un chronomètre (92, 94) propre à chronométrer les moments de transmission des signaux de commande d'ouverture et/ou de fermeture des interrupteurs (34, 36, 42, 46) à partir des paramètres de fonctionnement et des paramètres de commande reçus de la mémoire (80).

15. Ensemble selon la revendication 13 ou 14, le dispositif de commande (24) comprenant une unité de réglage (94) propre à délivrer des commandes numériques de variation du courant d'alimentation (Ig) selon un profil prédéfini (P6) à un convertisseur digital analogique pour commander les générateurs de courant (40, 44).

16. Ensemble selon l'une quelconque des revendications 13 à 15, le dispositif de commande (24) comprenant :
- un circuit d'acquisition (84) d'informations relatives à la tension (V_{CE}) entre l'électrode de collecteur et l'électrode d'émetteur du composant électronique de puissance (12, 14, 16), et
- un bloc (88) de filtrage temporel des informations acquises par le circuit d'acquisition (84),
- l'unité de pilotage (79) étant propre déterminer l'état du composant électronique de puissance (12, 14, 16) à partir des informations filtrées par le bloc de filtrage temporel (88), l'unité de pilotage (79) étant également apte à contrôler la cohérence entre les consignes de commande de puissance, et l'état du composant électronique de puissance (12, 14, 16).

17. Ensemble selon l'une quelconque des revendications 13 à 16, comprenant un allumeur (6) comprenant :
- ledit dispositif de commande (24), et
- une mémoire (23) effaçable et réinscriptible, ladite mémoire (23) étant munie de contacts électriques propres à être connectés à un ordinateur pour recevoir des paramètres de commande et paramètres de fonctionnement, ladite mémoire (23) étant connectée à la mémoire (80) du dispositif de commande (24) pour lui transmettre lesdits paramètres de commande et lesdits paramètres de fonctionnement.

## Patentansprüche

1. Schaltung (26, 28, 30) zum Steuern des Durchschaltens und Sperrens einer elektronischen Leistungskomponente (12, 14, 16), wobei die elektronische Leistungskomponente (12, 14, 16) eine Steuerelektrode, eine Emitter-Elektrode und eine Kollektor-Elektrode besitzt, **dadurch gekennzeichnet, dass** die Schaltung eine H-Brücke enthält, die Folgendes umfasst:
- einen ersten vertikalen Zweig (33A), der einen ersten Unterbrecher (34) und einen ersten digital gesteuerten Stromgenerator (40) enthält, wobei der erste Unterbrecher (34) von dem ersten Stromgenerator (40) durch einen Mittelpunkt (32A) getrennt ist, der dazu bestimmt ist, mit der Emitter-Elektrode der elektronischen Leistungskomponente (12, 14, 16) verbunden zu werden; und
- einen zweiten vertikalen Zweig (33B), der zu dem ersten vertikalen Zweig (33A) parallel ist, wobei der zweite vertikale Zweig (33B) einen zweiten Unterbrecher (36) und einen zweiten digital gesteuerten Stromgenerator (44) enthält, wobei der zweite Unterbrecher (36) von dem zweiten Generator (44) durch einen Mittelpunkt (32B) getrennt ist, der dazu bestimmt ist, mit der Steuerelektrode der elektronischen Leistungskomponente (12, 14, 16) verbunden zu werden;
- wobei der erste Stromgenerator (40) einen Versorgungsstrom (Ig) liefern kann, der in eine erste Richtung (F1) gelenkt wird, um die Steuerelektrode der elektronischen Leistungskomponente (12, 14, 16) zu versorgen; und wobei der zweite Stromgenerator (44) einen Versorgungsstrom (Ig) liefern kann, der in eine zweite Richtung (F2) entgegengesetzt zu der ersten Richtung (F1) gelenkt wird, um die Emitter-Elektrode der elektronischen Leistungskomponente (12, 14, 16) zu versorgen.

2. Steuerschaltung (26, 28, 30) nach Anspruch 1, wobei die H-Brücke einen dritten Unterbrecher (42), der zu dem ersten Stromgenerator (40) parallel geschaltet ist, und einen vierten Unterbrecher (46), der zu dem zweiten Stromgenerator (44) parallel geschaltet ist, enthält und wobei die Schaltung (26, 28, 30) eine Stromquelle (50, 57) umfasst, die die H-Brücke versorgen kann, wobei die Stromquelle zwischen einerseits den ersten (34) und den zweiten (36) Unterbrecher und andererseits den ersten (40) und den zweiten (44) Stromgenerator geschaltet ist.

3. Steuerschaltung (26, 28, 30) nach Anspruch 2, wobei die Spannungsquelle (50, 57) einen Kondensator (50) umfasst.

4. Steuerschaltung (26, 28, 30) nach einem der Ansprüche 1 bis 3, wobei die Unterbrecher (34, 36, 42, 44) MOS-Transistoren sind.

5. Verfahren zum Steuern einer Steuerschaltung (26, 28, 30) nach einem der Ansprüche 1 bis 4, **dadurch gekennzeichnet, dass** es in einer Steuerung zum Sperren der elektronischen Leistungskomponente (12, 14, 16) einen Schritt (62) des Lieferns durch den ersten Stromgenerator (40) eines Versorgungsstroms (Ig) umfasst, wobei der zweite Unterbrecher (36) in einem Zustand ist, in dem er in der ersten Richtung (F1) durchlässt.

6. Steuerverfahren nach Anspruch 5, wobei das Verfahren einen vorhergehenden Schritt (60) des Versetzens des zweiten Unterbrechers (36) in einen Zustand, in dem er in der ersten Richtung (F1) durchlässt, umfasst, wobei der erste Unterbrecher (34) in dem Zustand ist, in dem er in der ersten Richtung (F1) durchlässt.

7. Steuerverfahren nach Anspruch 5 oder 6, das durch die Schaltung nach Anspruch 2 ausgeführt wird, wobei das Verfahren Folgendes umfasst:
- einen Schritt (64) des Versetzens des dritten Unterbrechers (42) in einen Zustand, in dem er in der ersten Richtung (F1) durchlässt; wobei der zweite Unterbrecher (36) in dem Zustand ist, in dem er in der ersten Richtung (F1) durchlässt;
- einen Schritt (64) des Lieferns durch die Stromquelle (50, 57) eines Stromimpulses, der in die erste Richtung (F1) gelenkt wird.

8. Steuerverfahren nach einem der Ansprüche 5 bis 7, wobei das Verfahren in einer Steuerung des Durchschaltens der elektronischen Leistungskomponente (12, 14, 16) einen Schritt (70) des Lieferns eines Versorgungsstroms (Ig) durch den zweiten Stromgenerator (44) umfasst.

9. Steuerverfahren nach Anspruch 8, das durch die Schaltung nach Anspruch 2 ausgeführt wird, wobei das Verfahren einen vorherigen Schritt (68) des Versetzens des vierten Unterbrechers (46) in einen Zustand, in dem er in der zweiten Richtung (F2) durchlässt, umfasst, wobei der dritte Unterbrecher (42) in einem Zustand ist, in dem er in der zweiten Richtung (F2) durchlässt.

10. Steuerverfahren nach Anspruch 8 oder 9, das durch die Schaltung nach Anspruch 2 ausgeführt wird, wobei das Verfahren Folgendes umfasst:
- einen Schritt (62) des Versetzens des ersten (34) und des vierten (46) Unterbrechers in einen Zustand, in dem sie in der entgegengesetzten zweiten Richtung (F2) durchlassen; und
- einen Schritt (72) des Lieferns durch die Stromquelle (50, 57) eines Stromimpulses in der zweiten Richtung (F2).

11. Steuerverfahren nach Anspruch 7 oder 10, das durch die Schaltung nach Anspruch 3 ausgeführt wird, wobei der Schritt (64, 72) des Lieferns des Stromimpulses durch Entladen des Kondensators (50) ausgeführt wird.

12. Steuerverfahren nach einem der Ansprüche 5 bis 11, wobei der Schritt des Lieferns eines Versorgungsstroms (Ig) einen Schritt (62, 70) des allmählichen Verringerns im Verlauf der Zeit des Versorgungsstroms (Ig) in Übereinstimmung mit einem im Voraus definierten Profil umfasst.

13. Anordnung, die wenigstens eine Steuerschaltung (26, 28, 30) nach einem der Ansprüche 1 bis 4 und eine Vorrichtung (24) zum Steuern der wenigstens einen Steuerschaltung (26, 28, 30) umfasst, wobei die Steuervorrichtung (24) Leistungssteuerungs-Sollwerte empfangen kann und die Steuerschaltung (26, 28, 30) steuern kann, um wenigstens eine elektronische Leistungskomponente (12, 14, 16) als Funktion der Leistungssteuerungs-Sollwerte durchzuschalten und zu sperren, wobei die Vorrichtung (24) Folgendes umfasst:
- eine Steuereinheit (79), die Leistungssteuerungs-Sollwerte in Signale zum Steuern des Durchschaltens und/oder Sperrens der Unterbrecher (34, 36, 42, 46) und in Steuersignale, um an die Stromgeneratoren (40, 44) der Steuerschaltung (26, 28, 30) eine niedrige Spannung und/oder eine hohe Spannung anzulegen, umsetzen kann;
- einen Speicher (80) zum Speichern von Betriebsparametern (P1, P2, P3, P4, P5, P6, P7, P8) der oder jeder elektronischen Leistungskomponente (12, 14, 16) und von Parametern zum Steuern des Stroms (Ig), der in die Steuerelektrode und in die Emitter-Elektrode der oder jeder elektronischen Leistungskomponente (12, 14, 16) eingegeben werden soll, wobei der Speicher (80) löschbar und wieder beschreibbar ist; und
- eine Peripherie-Logikeinheit (82), die von dem Speicher (30) die Betriebsparameter und die Parameter für die Steuerung des Versorgungsstroms (Ig) empfangen kann, wobei die Peripherie-Logikeinheit (82) Aufgaben für die Steuereinheit (79) als Funktion der empfangenen Betriebsparameter und Stromsteuerungsparameter ausführen kann.

14. Anordnung nach Anspruch 13, wobei die Steuervorrichtung (24) wenigstens ein Chronometer (92, 94) umfasst, das die Zeitpunkte der Übertragung der Signale zum Steuern des Durchschaltens und/oder Sperrens der Unterbrecher (34, 36, 42, 46) anhand der von dem Speicher (80) empfangenen Betriebsparameter und Steuerparameter messen kann.

15. Anordnung nach Anspruch 13 oder 14, wobei die Steuervorrichtung (24) eine Regulierungseinheit (94) umfasst, die digitale Befehle zum Verändern des Versorgungsstroms (Ig) in Übereinstimmung mit einem im Voraus definierten Profil (P6) an einen Digital/Analog-Umsetzer liefern kann, um die Stromgeneratoren (40, 44) zu steuern.

16. Anordnung nach einem der Ansprüche 13 bis 15, wobei die Steuervorrichtung (24) Folgendes umfasst:
- eine Schaltung (84) zum Erfassen von Informationen bezüglich der Spannung (V_{CE}) zwischen der Kollektor-Elektrode und der Emitter-Elektrode der elektronischen Leistungskomponente (12, 14, 16) und
- einen Block (88) zum zeitlichen Filtern der durch die Erfassungsschaltung (84) erfassten Informationen,
- wobei die Steuereinheit (79) den Zustand der elektronischen Leistungskomponente (12, 14, 16) anhand der durch den Zeitfilterungsblock (88) gefilterten Informationen bestimmen kann, wobei die Steuereinheit (79) außerdem die Kohärenz zwischen den Leistungssteuerungs-Sollwerten und dem Zustand der elektronischen Leistungskomponente (12, 14, 16) steuern kann.

17. Anordnung nach einem der Ansprüche 13 bis 16, die eine Zündeinrichtung (6) enthält, die Folgendes umfasst:
- die Steuervorrichtung (24) und
- einen Speicher (23), der löschbar und wieder beschreibbar ist, wobei der Speicher (23) mit elektrischen Kontakten versehen ist, die mit einem Computer verbunden werden können, um Steuerparameter und Betriebsparameter zu empfangen, wobei der Speicher (23) mit dem Speicher (80) der Steuervorrichtung (24) verbunden ist, um an ihn die Steuerparameter und die Betriebsparameter zu übertragen.

## Claims

1. A circuit (26, 28, 30) for controlling the opening and closing of a power electronics component (12, 14, 16), the power electronics component (12, 14, 16) having a gate electrode, an emitter electrode and a collector electrode, **characterized in that** the circuit comprises an H-bridge comprising:
- a first vertical branch (33A) comprising a first switch (34) and a first current generator (40) controlled digitally, the first switch (34) being separated from the first current generator (40) by a middle point (32A) intended to be connected to the emitter electrode of the power electronics component (12, 14, 16); and
- a second vertical branch (33B) parallel to the first vertical branch (33A), the second vertical branch (33B) comprising a second switch (36) and a second current generator (44) controlled digitally, the second switch (36) being separated from the second generator (44) by a middle point (32B) intended to be connected to the gate electrode of the power electronics component (12, 14, 16);
- the first current generator (40) being suitable for delivering a supply current (Ig) directed in a first direction (F1) in order to supply the gate electrode of the power electronics component (12, 14, 16); and the second current generator (44) being suitable for delivering a supply current (Ig) directed in a second direction (F2) opposite to the first direction (F1) in order to supply the emitter electrode of the power electronics component (12, 14, 16).

2. A control circuit (26, 28, 30) according to claim 1, in which the H-bridge includes a third switch (42) connected in parallel to the first current generator (40), and a fourth switch (46) connected in parallel to the second current generator (44), and in that the circuit (26, 28, 30) includes a current source (50, 57) suitable for supplying the H-bridge, said current source being connected between, on the one hand, the first (34) and the second (36) switches, and, on the other hand, the first (40) and the second (44) current generators.

3. A control circuit (26, 28, 30) according to claim 2, in which the voltage source (50, 57) comprises a capacitor (50).

4. A control circuit (26, 28, 30) according to any one of claims 1 to 3, in which the switches (34, 36, 42, 44) are MOS transistors.

5. A method for driving a control circuit (26, 28, 30) according to any one of claims 1 to 4, **characterized in that** it includes, upon a command for closing the power electronics component (12, 14, 16), a step (62) for the delivery of a supply current (Ig) by the first current generator (40), the second switch (36) being in the state of conduction in the first direction (F1).

6. A driving method according to claim 5, which method includes a preliminary step (60) for placing the second switch (36) into the state of conduction in said first direction (F1), the first switch (34) being in the state of conduction in said first direction (F1).

7. A driving method according to either claim 5 or Claim 6 and implemented by the circuit according to claim 2, which method includes:
- a step (64) for placing the third switch (42) into the state of conduction in the first direction (F1), the second switch (36) being in the state of conduction in the first direction (F1);
- a step (64) for the delivery, by the current source (50, 57), of a current pulse directed in the first direction (F1).

8. A driving method according to any one of claims 5 to 7, which method includes, upon a command for opening the power electronics component (12, 14, 16), a step (70) for the delivery of a supply current (Ig) by the second current generator (44).

9. A driving method according to claim 8 and implemented by the circuit according to claim 2, which method includes a preliminary step (68) for placing the fourth switch (46) into the state of conduction in said second direction (F2), the third switch (42) being in the state of conduction in said second direction (F2).

10. A driving method according to either claim 8 or claim 9 implemented by the circuit according to Claim 2, which method includes:
- a step (72) for placing the first (34) and the fourth (46) switches into the state of conduction in said second opposite direction (F2); and
- a step (72) for the delivery, by the current source (50, 57), of a current pulse in said second direction (F2).

11. A driving method according to either claim 7 or claim 10 and implemented by the circuit according to claim 3, in which the step (64, 72) for delivering the current pulse is implemented by the discharging of the capacitor (50).

12. A driving method according to any one of claims 5 to 11, in which the step for delivering a supply current (Ig) comprises a step (62, 70) for the gradual decrease over time in the supply current (Ig) according to a predefined profile.

13. Set comprising at least one control circuit (26, 28, 30) according to any one of claims 1 to 4 and a control device (24) of said ate least one control circuit (26, 28, 30), the control device (24) being suitable for receiving power control instructions, and for controlling the control circuit (26, 28, 30) in order to open and close at least one power electronics component (12, 14, 16) according to the power control instructions, the device (24) comprising:
- a driving unit (79) able to convert power control instructions into signals for controlling the opening and/or closing of the switches (34, 36, 42, 46) and into signals for controlling the switching on and/or switching off of the current generators (40, 44) of the control circuit (26, 28, 30);
- a memory (80) for storing operating parameters (P1, P2, P3, P4, P5, P6, P7, P8) of the or each power electronics component (12, 14, 16), and control parameters for the current (Ig) intended to be applied to the gate electrode and to the emitter electrode of the or each power electronics component, said memory (80) being erasable and rewritable; and
- a peripheral logic unit (82) able to receive from said memory (30) the operating parameters and the control parameters for the supply current (Ig), the peripheral logic unit (82) being able to execute tasks for the driving unit (79) according to the received operating parameters and current control parameters.

14. Set according to claim 13, the control device (24) comprising at least one timer (92, 94) suitable for timing the moments of transmission of the control signals for opening and/or closing the switches (34, 36, 42, 46) based on the operating parameters and the control parameters received from the memory (80).

15. Set according to either claim 13 or claim 14, the control device (24) comprising a regulating unit (94) suitable for delivering digital commands for varying the supply current (Ig) according to a predefined profile (P6) to a digital-to-analogue converter in order to control the current generators (40, 44).

16. Set according to any one of claims 13 to 15, the control device (24) comprising:
- a circuit (84) for acquiring information relating to the voltage (V_{CE}) between the collector electrode and the emitter electrode of the power electronics component (12, 14, 16), and
- a time-domain filtering block (88) for filtering information acquired by the acquisition circuit (84),
- the driving unit (79) being suitable for determining the state of the power electronics component (12, 14, 16) based on information filtered by the time-domain filtering block (88), the driving unit (79) being also able to control the consistency between the power control instructions and the state of the power electronics component (12, 14, 16).

17. Set according to any one of claims 13 to 16, comprising an igniter (6) comprising:
- a control device (24) according to any one of Claims 13 to 16, and
- an erasable and rewritable memory (23), said memory (23) being equipped with electrical contacts suitable for being connected to a computer in order to receive control parameters and operating parameters, said memory (23) being connected to the memory (80) of the control device (24) in order to transmit to it said control parameters and said operating parameters.
